# EUROPEAN PATENT APPLICATION

(11) **EP 4 807 744 A1**
(43) Date of publication of application: **16.09.2026**
(21) Application number: 25212207.2
(22) Date of filing: 30.10.2025
(51) Int. Cl.: G11C 16/08, G11C 16/10, G11C 16/32, G11C 16/04, G11C 16/30

(54) **MEMORY DEVICE AND PROGRAMING METHOD OF MEMORY DEVICE**

(30) Priority: 10.03.2025 KR 20250030763
(71) Applicant: SK hynix Inc., Bubal-eub Icheon-si Gyeonggi-do 17336 (KR)
(72) Inventor: KIM, Jong Woo, 17336 Icheon-si (KR); JO, Eun Woo, 17336 Icheon-si (KR)
(74) Representative: Isarpatent

(57) **Abstract**

A memory device includes memory cells and a peripheral circuit. The memory cells are coupled to a plurality of word lines. The peripheral circuit is configured to, in a first interval, while a program voltage is applied to a selected word line among the plurality of word lines, apply a pre-program pass voltage to one or more adjacent word lines adjacent to the selected word line in a first sub-interval included in the first interval, and discharge the one or more adjacent word lines in a second sub-interval included in the first interval, and in a second interval, apply a program pass voltage to the one or more adjacent word lines while the program voltage is applied to the selected word line.

## Description

### CROSS-REFERENCES TO RELATED APPLICATION

The present application claims priority under 35 U.S.C. § 119(a) to Korean application number 10-2025-0030763 filed on March 10, 2025, which is incorporated herein by reference in its entirety.

### BACKGROUND

### 1.TECHNICAL FIELD

Various embodiments of the present disclosure generally relate to a memory device.

### 2. RELATED ART

The semiconductor device is a key component of electronic devices and has various application fields in modern times, for example, it can be utilized in technologies such as computing, communications, artificial intelligence, and memory. The semiconductor device may be configured to include transistors, diodes, and integrated circuits (ICs).

A program operation of a semiconductor memory device can store data in a memory cell by applying a high program voltage to a word line connected to the memory cell. At this time, it is important that the program voltage quickly reaches a target level and is stably maintained. If settling of the program voltage is delayed, program time may increase, and overall memory performance may be degraded. Therefore, quickly settling the program voltage may be a key factor in improving a speed of the program operation.

### SUMMARY

In an embodiment of the present disclosure, a memory device may include memory cells and a peripheral circuit. The memory cells may be coupled to a plurality of word lines. The peripheral circuit may be configured to, in a first interval, while a program voltage is applied to a selected word line among the plurality of word lines, apply a pre-program pass voltage to one or more adjacent word lines adjacent to the selected word line in a first sub-interval included in the first interval, and discharge the one or more adjacent word lines in a second sub-interval included in the first interval, and in a second interval, apply a program pass voltage to the one or more adjacent word lines while the program voltage is applied to the selected word line.

In an embodiment of the present disclosure, a programming method of a memory device may include, in a first interval, while a program voltage is applied to a selected word line, applying a pre-program pass voltage to one or more adjacent word lines adjacent to a selected word line in a first sub-interval included in the first interval, and discharging the pre-program pass voltage in a second sub-interval included in the first interval, and in a second interval, applying a program pass voltage to the one or more adjacent word lines while the program voltage is applied to the selected word line.

In an embodiment of the present disclosure, a programming method of a memory device may include, in a first interval, while a first voltage node is coupled to a selected word line and a second voltage node is coupled to one or more adjacent word lines adjacent to the selected word line, discharging the second voltage node in at least one sub-interval included in the first interval, wherein the first voltage node is a node from which a program voltage is output, and the second voltage node is a node from which a pre-program pass voltage is output.

### BRIEF DESCRIPTION OF THE DRAWINGS

FIG. 1 is a block diagram illustrating a memory device according to an embodiment of the present disclosure.
FIG. 2 is a circuit diagram illustrating a memory block according to an embodiment of the present disclosure.
FIG. 3 is a timing diagram illustrating a program operation according to an embodiment of the present disclosure.
FIG. 4 is a timing diagram illustrating a program operation according to an embodiment of the present disclosure.
FIG. 5 is a block diagram illustrating a decoder according to an embodiment of the present disclosure.
FIG. 6 is a block diagram illustrating a decoder according to an embodiment of the present disclosure.
FIG. 7 is a block diagram illustrating a voltage generation circuit and a decoder according to an embodiment of the present disclosure.
FIG. 8 is a timing diagram illustrating a program operation according to an embodiment of the present disclosure.
FIG. 9 is a flowchart illustrating a program operation of a memory device according to an embodiment of the present disclosure.

### DETAILED DESCRIPTION

Hereinafter, embodiments of the present disclosure will be described in more detail with reference to the accompanying drawings.

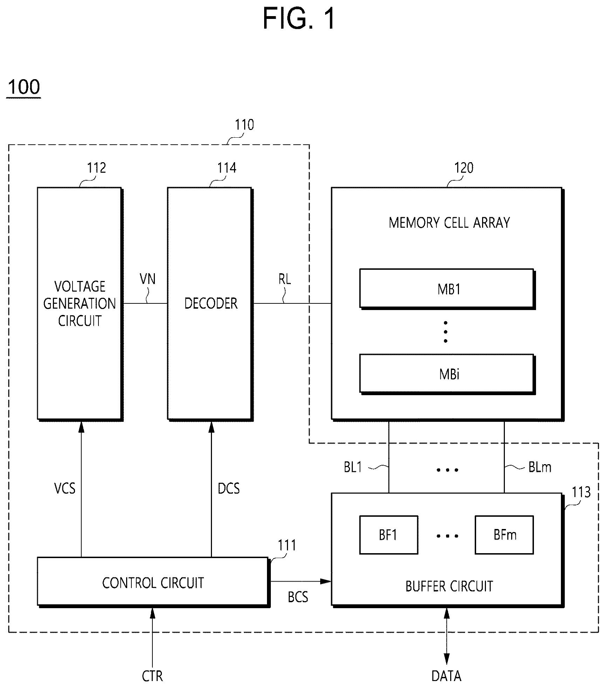

FIG. 1 is a block diagram illustrating a memory device 100 according to an embodiment of the present disclosure.

Referring to FIG. 1, the memory device 100 may operate in response to control from an external controller (not shown). The memory device 100 may store data DATA received from the controller by performing a program operation, and may output the stored data DATA to the controller by performing a read operation.

The memory device 100 may include a peripheral circuit 110 and a memory cell array 120.

The peripheral circuit 110 may store data in the memory cell array 120 and read data from the memory cell array 120. The peripheral circuit 110 may include a control circuit 111, a voltage generation circuit 112, a buffer circuit 113, and a decoder 114.

The control circuit 111 may control operations of the voltage generation circuit 112, the buffer circuit 113, and the decoder 114 to perform internal operations of the memory device 100, such as program operations, read operations, erase operations, and the like, in response to an external signal CTR received from the controller. For example, to control the voltage generation circuit 112, the control circuit 111 may generate a voltage control signal VCS and output it to the voltage generation circuit 112. To control the buffer circuit 113, the control circuit 111 may generate a buffer control signal BCS and output it to the buffer circuit 113. To control the decoder 114, the control circuit 111 may generate a decoder control signal DCS and output it to the decoder 114.

The voltage generation circuit 112 may generate various voltages (not shown) in response to the voltage control signal VCS and transmit the voltages to the buffer circuit 113, decoder 114, and other circuits of the memory device 100. For example, the voltage generation circuit 112 may output voltages, such as a pre-program voltage, a program voltage, a pre-program pass voltage, and a program pass voltage, to the decoder 114 through one or more voltage nodes VN.

The buffer circuit 113 may be coupled to the memory cell array 120 through bit lines BL1 to BLm. The buffer circuit 113 may include buffers BF1 to BFm coupled to the bit lines BL1 to BLm, respectively. The buffers BF1 to BFm may be coupled with memory cells (not shown) included in the memory cell array 120 through the bit lines BL1 to BLm. The buffers BF1 to BFm may receive and store data to be stored in the memory cells from the controller. The buffers BF1 to BFm may store data read from the memory cells for output to the controller. The buffers BF1 to BFm may operate simultaneously in response to the buffer control signal BCS, such that the memory cells coupled with the bit lines BL1 to BLm, respectively, may be accessed simultaneously.

The decoder 114 may be coupled to the memory cell array 120 through row lines RL. The decoder 114 may apply voltages transmitted from the voltage generation circuit 112 to the row lines RL in response to the decoder control signal DCS. The row lines RL may include drain selection lines, word lines, and source selection lines, which are coupled to each of the memory blocks MB1 to MBi, as will be described later.

The memory cell array 120 may include a plurality of memory blocks MB1 to MBi. The memory blocks MB1 to MBi may include memory cells in which data DATA is stored. The memory blocks MB1 to MBi may share the bit lines BL1 to BLm.

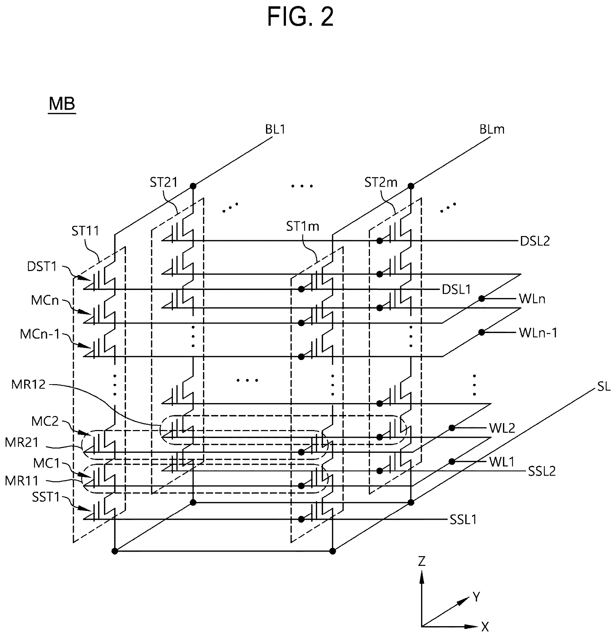

FIG. 2 is a circuit diagram illustrating a memory block MB according to an embodiment of the present disclosure. Each of the memory blocks MB1 to MBi of FIG. 1 may be configured similarly to the memory block MB.

Referring to FIG. 2, the memory block MB may include strings ST11 to ST1m, ST21 to ST2m. Each of the strings ST11 to ST1m, ST21 to ST2m may extend along a vertical direction (Z direction). Within the memory block MB, m strings may be arranged in a row direction (X direction). In FIG. 2, two strings are shown arranged in a column direction (Y direction), but this is for illustrative purposes only, and three or more strings may be arranged in the column direction (Y direction).

The strings ST11 to ST1m, ST21 to ST2m may be configured identically. For example, the string ST11 may include a source selection transistor SST1, memory cells MC1 to MCn, and a drain selection transistor DST1, coupled in series with each other between the source line SL and the bit line BL1. A source of the source selection transistor SST1 may be coupled to the source line SL, and a drain of the drain selection transistor DST1 may be coupled to the bit line BL1. The memory cells MC1 to MCn may be coupled in series with each other between the source selection transistor SST1 and the drain selection transistor DST1. In an embodiment, a plurality of source selection transistors may be coupled in series between the source line SL and the memory cell MC1. In an embodiment, a plurality of drain selection transistors may be coupled in series between the bit line BL1 and the memory cell MCn.

Source selection transistors at the same position in a vertical direction may be configured as shown below. Specifically, the gates of the source selection transistors of strings arranged in the same row may be coupled to the same source selection line. For example, the gates of the source selection transistors of strings ST11 to ST1m in a first row may be coupled to a source selection line SSL1. For example, the gates of the source selection transistors of strings ST21 to ST2m in a second row may be coupled to a source selection line SSL2.

In an embodiment, source selection transistors of strings in two or more rows may be coupled in common to a single source selection line. For example, the source selection transistors of the first and second rows of strings ST11 to ST1m, ST21 to ST2m may be coupled in common to one source selection line, and the source selection transistors of the third and fourth rows of strings may be coupled in common to one source selection line.

Drain selection transistors at the same position in a vertical direction may be configured as shown below. Specifically, the gates of the drain selection transistors of strings arranged in the same row may be coupled to the same drain selection line. For example, the gates of the drain selection transistors of the strings ST11 to ST1m of the first row may be coupled to the drain selection line DSL1. For example, the gates of the drain selection transistors of the strings ST21 to ST2m of the second row may be coupled to the drain selection line DSL2.

Strings arranged in the same column may be coupled to the same bit line. For example, strings ST11, ST21 in a first column may be coupled to the bit line BL1. For example, strings ST1m, ST2m in an mth column may be coupled to the bit line BLm.

Gates of memory cells at the same position in a vertical direction may be coupled to the same word line. For example, in strings ST11 to ST1m and ST21 to ST2m, memory cells that are at the same position as the memory cell MC1 in the vertical direction may be coupled to the word line WL1.

Among the memory cells, memory cells coupled to the same word line in the same row may constitute one memory region. For example, memory cells coupled to the word line WL1 in the first row may constitute one memory region MR11. For example, memory cells coupled to the word line WL1 in the second row may constitute one memory region MR12. For example, memory cells coupled to a word line WL2 in the first row may constitute one memory region MR21. Depending on the number of rows, each word line may be coupled to multiple memory regions. The memory cells constituting one memory region may be accessed simultaneously.

In an embodiment, the memory block MB may be further coupled to at least one dummy word line other than the word lines WL1 to WLn. In this case, the memory block MB may further include dummy memory cells coupled to dummy word lines.

In the following description, a selected word line may be a word line coupled to target memory cells on which a program operation is performed among word lines WL1 to WLn. One or more adjacent word lines may be word lines adjacent to the selected word line. For example, when the selected word line is the word line WL1, an adjacent word line may be the word line WL2.

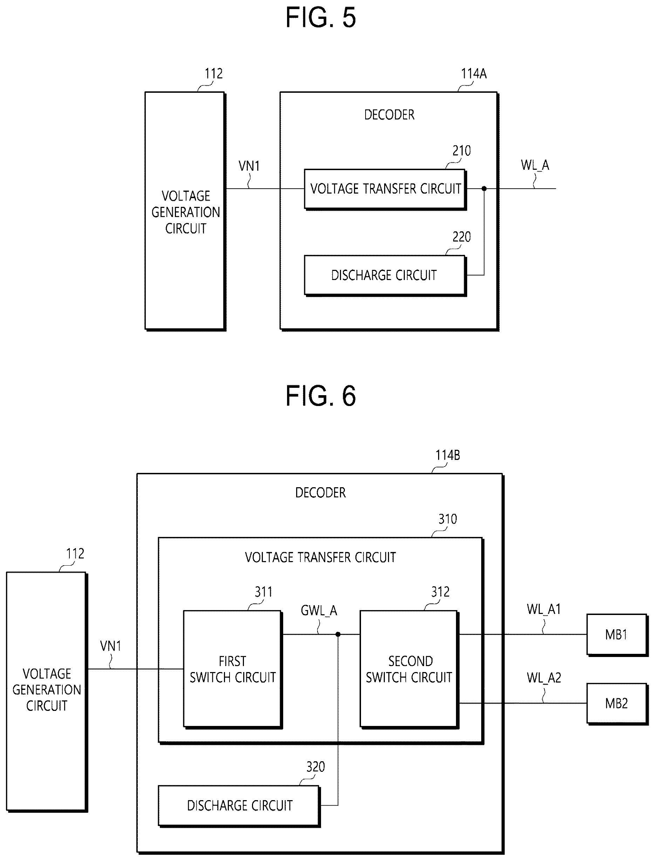

Referring back to FIG. 1, the peripheral circuit 110 may, in a first interval of a program operation, apply a pre-program pass voltage to one or more adjacent word lines during a first sub-interval included in the first interval and may discharge one or more adjacent word lines during a second sub-interval included in the first interval while applying a program voltage to a selected word line. As will be described with reference to FIGS. 5 to 7, a discharge circuit for discharging the one or more adjacent word lines may be included in the voltage generation circuit 112 or the decoder 114. Operations of applying the pre-program pass voltage to the one or more adjacent word lines and discharging the one or more adjacent word lines may be alternately repeated. Further, in a second interval, the peripheral circuit 110 may apply a program pass voltage to one or more adjacent word lines while applying a program voltage to a selected word line. The pre-program pass voltage may be lower than the program pass voltage.

In an embodiment, the peripheral circuit 110 may, in the first interval of a program operation, discharge a second voltage node outputting a pre-program pass voltage during at least one sub-interval included in the first interval, while coupling a first voltage node outputting a program voltage from the voltage generation circuit 112 to a selected word line and coupling the second voltage node outputting the pre-program pass voltage from the voltage generation circuit 112 to one or more adjacent word lines adjacent to the selected word line. Further, in the second interval, the peripheral circuit 110 may couple a third voltage node outputting the program pass voltage from the voltage generation circuit 112 to the one or more adjacent word lines while coupling the first voltage node to the selected word line.

As will be described in detail below, discharging the one or more adjacent word lines or discharging the second voltage node outputting the pre-program pass voltage during a predetermined sub-interval included in the first interval may prevent a far part of the adjacent word lines, which is remote from the decoder 114, from excessively increasing to a high voltage level due to a coupling effect relative to the selected word line. Accordingly, during the second interval, a voltage level of the selected word line may quickly settle to the program voltage. As a result, the program performance of the memory device 100 may be improved. The word "predetermined" as used herein with respect to a parameter, such as a predetermined timing, time, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm but before the parameter is used in the process or algorithm.

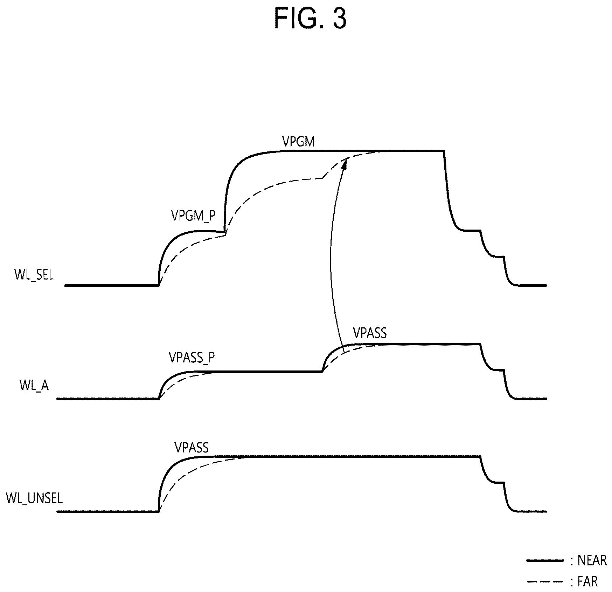

FIG. 3 is a timing diagram illustrating a program operation according to an embodiment of the present disclosure.

Referring to FIG. 3, a pre-program voltage VPGM_P may be first applied to a selected word line WL_SEL of a target memory block on which a program operation is performed. Specifically, the decoder 114 may, under the control of the control circuit 111, couple a voltage node among the voltage nodes VN outputting the pre-program voltage VPGM_P to the selected word line WL_SEL. Subsequently, a program voltage VPGM higher than the pre-program voltage VPGM_P may be applied to the selected word line WL_SEL. Specifically, the decoder 114 may, under the control of the control circuit 111, couple a voltage node among the voltage nodes VN outputting the program voltage VPGM to the selected word line WL_SEL.

Because of propagation delay and resistance, a near part of the selected word line WL_SEL, which is close to the decoder 114, may rise in voltage level as indicated by a solid line and a far part of the selected word line WL_SEL, which is far from the decoder 114, may rise in voltage level as indicated by a dotted line. The voltage level of the far part of the selected word line WL_SEL may rise more slowly than that of the near part of the selected word line WL_SEL.

While the pre-program voltage VPGM_P and the program voltage VPGM are sequentially applied to the selected word line WL_SEL, a program pass voltage VPASS may be applied to unselected word lines WL_UNSEL, which are the word lines other than the selected word line WL_SEL and adjacent word lines WL_A, in the target memory block. Specifically, the decoder 114 may, under the control of the control circuit 111, couple a voltage node among the voltage nodes VN outputting the program pass voltage VPASS to the unselected word lines WL_UNSEL.

In an embodiment, the pre-program voltage VPGM_P may be the same as the program pass voltage VPASS.

The pre-program pass voltage VPASS_P may be first applied to the adjacent word lines WL_A. Specifically, the decoder 114 may, under the control of the control circuit 111, couple the voltage node among the voltage nodes VN outputting the pre-program pass voltage VPASS_P to the adjacent word lines WL_A. Subsequently, the program pass voltage VPASS higher than the pre-program pass voltage VPASS_P may be applied to the adjacent word lines WL_A. Specifically, the decoder 114 may, under the control of the control circuit 111, couple the voltage node among the voltage nodes VN outputting the program pass voltage VPASS to the adjacent word lines WL_A.

At this time, a near part of the adjacent word lines WL_A, which is close to the decoder 114, may rise in voltage level as indicated by a solid line, and a far part of the adjacent word lines WL_A, which is remote from the decoder 114, may rise in voltage level as indicated by a dotted line, due to propagation delay and resistance. The voltage level of the far part of the adjacent word lines WL_A may rise more slowly than that of the near part of the adjacent word lines WL_A.

The timing at which the program pass voltage VPASS is applied to the adjacent word lines WL_A may be later than the timing at which the program voltage VPGM is applied to the selected word line WL_SEL. When a voltage applied to the adjacent word lines WL_A rises from the pre-program pass voltage VPASS_P to the program pass voltage VPASS, the voltage level of the far part of the selected word line WL_SEL may reach the program voltage VPGM more quickly due to a coupling effect occurring between the adjacent word lines WL_A and the selected word line WL_SEL.

In summary, during the application of the program voltage VPGM to the selected word line WL_SEL, a two-step method may be applied in which the voltage applied to the adjacent word lines WL_A is not increased at once to the program pass voltage VPASS, but is first increased to the pre-program pass voltage VPASS_P and then increased to the program pass voltage VPASS. Therefore, the voltage level of the selected word line WL_SEL may quickly settle to the program voltage VPGM, thereby improving the program performance of the memory device 100.

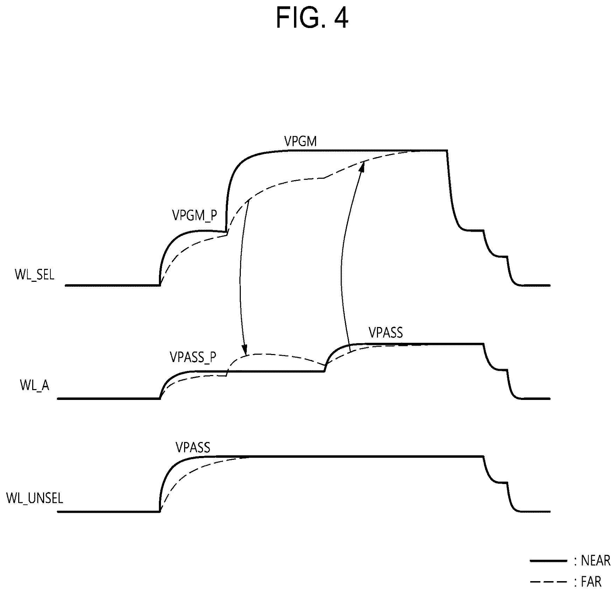

FIG. 4 is a timing diagram illustrating a program operation according to an embodiment of the present disclosure.

Referring to FIG. 4, in some cases, while the pre-program pass voltage VPASS_P is applied to the adjacent word lines WL_A, the far part of the adjacent word lines WL_A may rise to a voltage level higher than expected (for example, higher than the pre-program pass voltage VPASS_P) due to a coupling effect with the far part of the selected word line WL_SEL. In this case, the voltage level of the far part of the adjacent word lines WL_A might not fall back to an appropriate voltage level (for example, the pre-program pass voltage VPASS_P) until the program pass voltage VPASS is applied. As a result, when the program pass voltage VPASS is applied to the adjacent word lines WL_A, sufficient voltage boosting might not occur in the far part of the adjacent word lines WL_A, and thus, the speed at which the voltage level of the far part of the selected word line WL_SEL reaches the program voltage VPGM may be slower compared to the case described with reference to FIG. 3.

FIG. 5 is a block diagram illustrating a decoder 114A according to an embodiment of the present disclosure. The decoder 114A may be an example of the decoder 114 of FIG. 1.

Referring to FIG. 5, the decoder 114A may include a voltage transfer circuit 210 and a discharge circuit 220. A voltage node VN1 may be one of the voltage nodes VN of FIG. 1.

The voltage transfer circuit 210 may, under the control of the control circuit 111, couple the voltage node VN1 outputting the pre-program pass voltage VPASS_P to the adjacent word lines WL_A, respectively. When the voltage generation circuit 112 outputs the pre-program pass voltage VPASS_P to the voltage node VN1, the voltage transfer circuit 210 may transfer the pre-program pass voltage VPASS_P from the voltage node VN1 to the adjacent word lines WL_A, respectively. For example, the voltage transfer circuit 210 may include switches coupled between the voltage node VN1 and the adjacent word lines WL_A.

The discharge circuit 220 may be coupled to the adjacent word lines WL_A. The discharge circuit 220 may, under the control of the control circuit 111, discharge the adjacent word lines WL_A, respectively. For example, the discharge circuit 220 may include switches coupled between the adjacent word lines WL_A and a ground node. In an embodiment, the discharge circuit 220 may be coupled to a node having a voltage level higher than a ground voltage.

The control circuit 111 may control the voltage generation circuit 112 to output the pre-program pass voltage VPASS_P to the voltage node VN1 and may control the voltage transfer circuit 210 and the discharge circuit 220 to be alternately and repeatedly activated while the program voltage VPGM is applied to the selected word line WL_SEL during the first interval of the program operation. Therefore, an operation of applying the pre-program pass voltage VPASS_P to the adjacent word lines WL_A by the activated voltage transfer circuit 210 and an operation of discharging the adjacent word lines WL_A by the activated discharge circuit 220 may be alternately performed.

FIG. 6 is a block diagram illustrating a decoder 114B according to an embodiment of the present disclosure. The decoder 114B may be an example of the decoder 114 of FIG. 1.

Referring to FIG. 6, the decoder 114B may include a voltage transfer circuit 310 and a discharge circuit 320.

The voltage transfer circuit 310 may include a first switch circuit 311 and a second switch circuit 312.

The first switch circuit 311 may, under the control of the control circuit 111, couple a voltage node VN1 to global adjacent word lines GWL_A, respectively. When the voltage generation circuit 112 outputs the pre-program pass voltage VPASS_P to the voltage node VN1, the first switch circuit 311 may transfer the pre-program pass voltage VPASS_P from the voltage node VN1 to the global adjacent word lines GWL_A, respectively. For example, the first switch circuit 311 may include switches coupled between the voltage node VN1 and the global adjacent word lines GWL_A.

The second switch circuit 312 may, under the control of the control circuit 111, couple the global adjacent word lines GWL_A to adjacent word lines WL_A1, respectively, or to adjacent word lines WL_A2, respectively. For example, when a target memory block on which the program operation is performed is a memory block MB1, the second switch circuit 312 may couple the global adjacent word lines GWL_A to the adjacent word lines WL_A1, respectively, and may transfer the pre-program pass voltage VPASS_P from the global adjacent word lines GWL_A to the adjacent word lines WL_A1, respectively. For example, the second switch circuit 312 may include switches coupled between the global adjacent word lines GWL_A and the adjacent word lines WL_A1.

The discharge circuit 320 may be coupled to the global adjacent word lines GWL_A. The discharge circuit 320 may, under the control of the control circuit 111, discharge the global adjacent word lines GWL_A, respectively. For example, the discharge circuit 320 may include switches coupled between the global adjacent word lines GWL_A and the ground node. In an embodiment, the discharge circuit 320 may be coupled to a node having a voltage level higher than the ground voltage.

The control circuit 111 may control the voltage generation circuit 112 to output the pre-program pass voltage VPASS_P to the voltage node VN1 and may control the first switch circuit 311 and the discharge circuit 320 to be alternately and repeatedly activated while the program voltage VPGM is applied to the selected word line WL_SEL during the first interval of the program operation. Additionally, while the first switch circuit 311 and the discharge circuit 320 are alternately and repeatedly activated, the control circuit 111 may control the second switch circuit 312 to remain activated. Accordingly, an operation of applying the pre-program pass voltage VPASS_P to the adjacent word lines coupled to the target memory block by the activated first switch circuit 311 and the activated second switch circuit 312 and an operation of discharging the global adjacent word lines GWL_A and the adjacent word lines by the activated discharge circuit 320 and the activated second switch circuit 312 may be alternately performed.

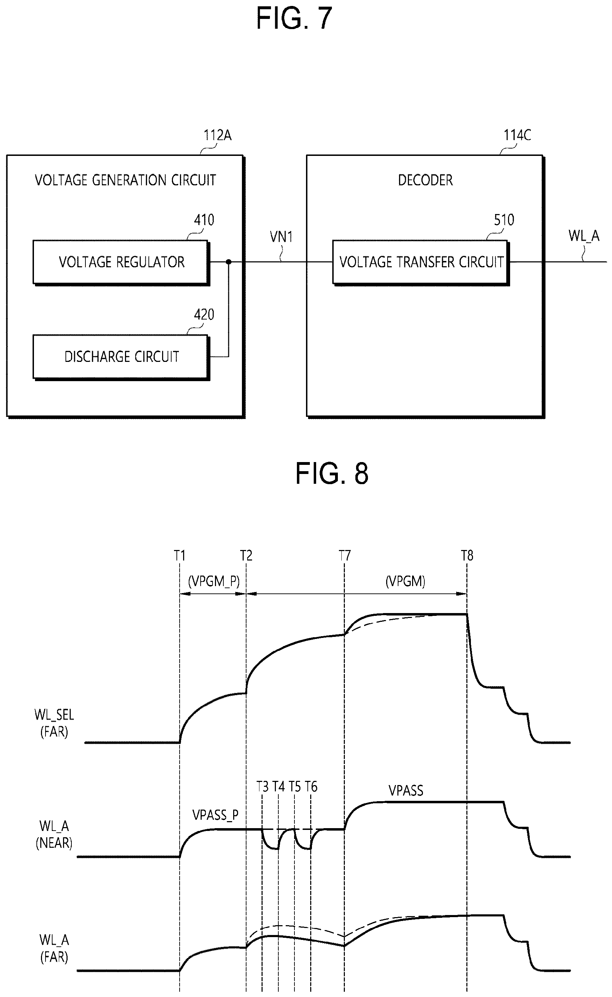

FIG. 7 is a block diagram illustrating a voltage generation circuit 112A and a decoder 114C according to an embodiment of the present disclosure. The voltage generation circuit 112A and the decoder 114C may be examples of the voltage generation circuit 112 and the decoder 114 of FIG. 1.

Referring to FIG. 7, the voltage generation circuit 112A may include a voltage regulator 410 and a discharge circuit 420.

The voltage regulator 410 may output the pre-program pass voltage VPASS_P to a voltage node VN1 under the control of the control circuit 111.

The discharge circuit 420 may be coupled to the voltage node VN1. The discharge circuit 420 may discharge the voltage node VN1 under the control of the control circuit 111. For example, the discharge circuit 420 may include a switch coupled between the voltage node VN1 and the ground node. In an embodiment, the discharge circuit 420 may be coupled to a node having a voltage level higher than the ground voltage.

The decoder 114C may include a voltage transfer circuit 510. The voltage transfer circuit 510 may, under the control of the control circuit 111, couple the voltage node VN1 to adjacent word lines WL_A, respectively. When the voltage generation circuit 112A outputs the pre-program pass voltage VPASS_P to the voltage node VN1, the voltage transfer circuit 510 may transfer the pre-program pass voltage VPASS_P from the voltage node VN1 to the adjacent word lines WL_A, respectively. For example, the voltage transfer circuit 510 may include switches coupled between the voltage node VN1 and the adjacent word lines WL_A.

The control circuit 111 may control the voltage regulator 410 and the discharge circuit 420 to be alternately and repeatedly activated while the program voltage VPGM is applied to the selected word line WL_SEL during the first interval of the program operation. Additionally, while the voltage regulator 410 and the discharge circuit 420 are alternately and repeatedly activated, the control circuit 111 may control the voltage transfer circuit 510 to remain activated. Accordingly, an operation of applying the pre-program pass voltage VPASS_P to the adjacent word lines WL_A by the activated voltage regulator 410 and the activated voltage transfer circuit 510 and an operation of discharging the voltage node VN1 and the adjacent word lines WL_A by the activated discharge circuit 420 and the activated voltage transfer circuit 510 may be alternately performed.

In an embodiment, the control circuit 111 may control the voltage regulator 410 and the voltage transfer circuit 510 to remain continuously activated and control the discharge circuit 420 to be activated only during at least one sub-interval included in the first interval while the program voltage VPGM is applied to the selected word line WL_SEL during the first interval of the program operation. When the discharge circuit 420 is activated while the voltage regulator 410 remains activated, the voltage level of the voltage node VN1 may become lower than the pre-program pass voltage VPASS_P. Therefore, while the discharge circuit 420 is deactivated, the pre-program pass voltage VPASS_P may be applied to the adjacent word lines WL_A, and while the discharge circuit 420 is activated, a voltage lower than the pre-program pass voltage VPASS_P may be applied to the adjacent word lines WL_A.

FIG. 8 is a timing diagram illustrating a program operation according to an embodiment of the present disclosure. In FIG. 8, dotted lines represent waveforms according to the embodiment of FIG. 4.

Referring to FIG. 8, an interval from a time point T1 to a time point T2 may be an interval in which the pre-program voltage VPGM_P is applied to the selected word line WL_SEL, and the pre-program pass voltage VPASS_P is applied to the adjacent word lines WL_A. An interval from the time point T2 to a time point T8 may be an interval in which the program voltage VPGM is applied to the selected word line WL_SEL.

In the interval from the time point T2 to a time point T7, while the program voltage VPGM is applied to the selected word line WL_SEL, an operation of applying the pre-program pass voltage VPASS_P to the adjacent word lines WL_A and an operation of discharging the adjacent word lines WL_A may be alternately repeated. For example, the pre-program pass voltage VPASS_P may be applied to the adjacent word lines WL_A from the time point T2 to a time point T3, from a time point T4 to a time point T5, and from a time point T6 to the time point T7. Meanwhile, from the time point T3 to the time point T4 and from the time point T5 to the time point T6, the operation of applying the pre-program pass voltage VPASS_P to the adjacent word lines WL_A is suspended, and the discharge circuits 220, 320, and 420 of FIGS. 5 to 7 are activated, thereby allowing the adjacent word lines WL_A to be discharged.

In an embodiment, while coupling a voltage node (VN1 of FIG. 7), from which the pre-program pass voltage VPASS_P is output, to the adjacent word lines WL_A from the time point T3 to the time point T4 and from the time point T5 to the time point T6, the voltage node (VN1 of FIG. 7) may be discharged.

Thus, in the intervals from the time point T3 to the time point T4 and from the time point T5 to the time point T6, a voltage level of a near part of the adjacent word lines WL_A may become lower than the pre-program pass voltage VPASS_P. At this time, a voltage level of a far part of the adjacent word lines WL_A might not drop as sharply as that of the near part of the adjacent word lines WL_A because of propagation delay and resistance but may drop gradually. Therefore, as described with reference to FIG. 4, a phenomenon in which the voltage level of the far part of the adjacent word lines WL_A rises due to the coupling effect on the far part of the selected word line WL_SEL may be suppressed.

An interval from the time point T7 to the time point T8 may be an interval in which the program pass voltage VPASS is applied to the adjacent word lines WL_A. If, at the time point T7, the voltage level of the far part of the adjacent word lines WL_A is lowered to an appropriate voltage level (for example, the pre-program pass voltage VPASS_P), the voltage level of the far part of the selected word line WL_SEL may be rapidly settled to the program voltage VPGM due to the coupling effect on the far part of the adjacent word lines WL_A. Thus, the program performance of the memory device 100 may be improved.

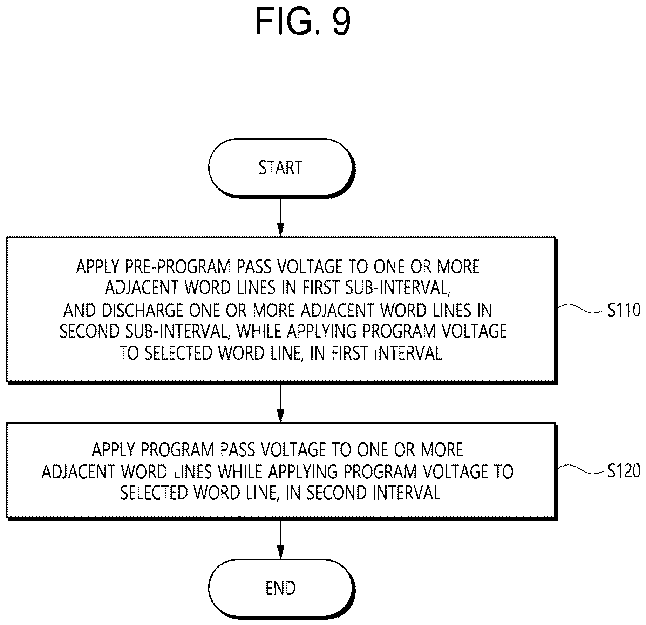

FIG. 9 is a flowchart illustrating a program operation of the memory device 100 according to an embodiment of the present disclosure.

Referring to FIG. 9, in an operation S110, the peripheral circuit 110 may apply the pre-program pass voltage VPASS_P to one or more adjacent word lines WL_A in a first sub-interval included in a first interval, and may discharge the one or more adjacent word lines WL_A in a second sub-interval included in the first interval, while applying the program voltage VPGM to the selected word line WL_SEL, in the first interval. The first interval may correspond to an interval from the time point T2 to the time point T7 in FIG. 8.

In an operation S120, the peripheral circuit 110 may apply the program pass voltage VPASS to the one or more adjacent word lines WL_A while applying the program voltage VPGM to the selected word line WL_SEL, in a second interval. The second interval may correspond to an interval from the time point T7 to the time point T8 in FIG. 8.

According to embodiments of the present disclosure, a memory device can provide improved program operation performance.

Concepts are disclosed in conjunction with examples and embodiments. Those skilled in the art will understand that various modifications, additions, combinations, and substitutions to the disclosed embodiments are possible without departing from the scope and technical concepts of the present disclosure. The embodiments disclosed in the present disclosure should be considered from an illustrative standpoint and not a restrictive standpoint. Therefore, the scope of the present disclosure is not limited to the provided descriptions. All changes within the meaning and range of equivalency of the claims are included within their scope. Furthermore, the embodiments may be combined to form additional embodiments,

## Claims

1. A memory device comprising:
memory cells coupled to a plurality of word lines; and
a peripheral circuit configured to:
in a first interval, while a program voltage is applied to a selected word line among the plurality of word lines:
apply a pre-program pass voltage to one or more adjacent word lines adjacent to the selected word line in a first sub-interval included in the first interval, and
discharge the one or more adjacent word lines in a second sub-interval included in the first interval, and
in a second interval, apply a program pass voltage to the one or more adjacent word lines while the program voltage is applied to the selected word line.

2. The memory device of claim 1, wherein the peripheral circuit is configured to alternately and repeatedly perform, in the first interval, an operation of applying the pre-program pass voltage to the one or more adjacent word lines and an operation of discharging the one or more adjacent word lines.

3. The memory device of claim 1, wherein the pre-program pass voltage is lower than the program pass voltage.

4. The memory device of claim 1, wherein the peripheral circuit is configured to apply, in an interval prior to the first interval, a pre-program voltage to the selected word line and the pre-program pass voltage to the one or more adjacent word lines.

5. The memory device of claim 4, wherein the pre-program voltage is lower than the program voltage.

6. The memory device of claim 1, wherein the peripheral circuit comprises:
a voltage generation circuit configured to output the pre-program pass voltage to a voltage node;
a voltage transfer circuit configured to selectively couple the voltage node to the one or more adjacent word lines; and
a discharge circuit coupled to the one or more adjacent word lines and configured to discharge the one or more adjacent word lines.

7. The memory device of claim 6, wherein the peripheral circuit further comprises a control circuit configured to activate the voltage transfer circuit in the first sub-interval and configured to activate the discharge circuit in the second sub-interval.

8. The memory device of claim 1, wherein the peripheral circuit comprises:
a voltage generation circuit configured to output the pre-program pass voltage to a voltage node;
a first switch circuit configured to selectively couple the voltage node to one or more global adjacent word lines;
a second switch circuit configured to selectively couple the one or more global adjacent word lines to the one or more adjacent word lines; and
a discharge circuit coupled to the one or more global adjacent word lines and configured to discharge the one or more global adjacent word lines.

9. The memory device of claim 8, wherein the peripheral circuit further comprises a control circuit configured to activate the first switch circuit and the second switch circuit in the first sub-interval and activate the second switch circuit and the discharge circuit in the second sub-interval.

10. The memory device of claim 1, wherein the peripheral circuit comprises:
a voltage regulator configured to output the pre-program pass voltage to a voltage node;
a voltage transfer circuit configured to selectively couple the voltage node to the one or more adjacent word lines; and
a discharge circuit coupled to the voltage node and configured to discharge the voltage node.

11. The memory device of claim 10, wherein the peripheral circuit further comprises a control circuit configured to activate the voltage regulator and the voltage transfer circuit in the first sub-interval and activate the voltage transfer circuit and the discharge circuit in the second sub-interval.

12. A programming method of a memory device, the method comprising:
in a first interval, while a program voltage is applied to a selected word line:
applying a pre-program pass voltage to one or more adjacent word lines adjacent to a selected word line in a first sub-interval included in the first interval; and
discharging the one or more adjacent word lines in a second sub-interval included in the first interval; and
in a second interval, applying a program pass voltage to the one or more adjacent word lines while the program voltage is applied to the selected word line.

13. The method of claim 12, wherein the applying of the pre-program pass voltage and the discharging of the one or more adjacent word lines are performed alternately and repeatedly.

14. The method of claim 12, wherein the pre-program pass voltage is lower than the program pass voltage.

15. The method of claim 12, further comprising, in an interval prior to the first interval:
applying a pre-program voltage to the selected word line; and
applying the pre-program pass voltage to the one or more adjacent word lines.

16. The method of claim 15, wherein the pre-program voltage is lower than the program voltage.

17. A programming method of a memory device, the method comprising, in a first interval, while a first voltage node is coupled to a selected word line and a second voltage node is coupled to one or more adjacent word lines adjacent to the selected word line, discharging the second voltage node in at least one sub-interval included in the first interval,
wherein the first voltage node is a node from which a program voltage is output, and the second voltage node is a node from which a pre-program pass voltage is output.

18. The method of claim 17, further comprising coupling a third voltage node, from which a program pass voltage is output, to the one or more adjacent word lines while the first voltage node is coupled to the selected word line in a second interval.

19. The method of claim 17, wherein the pre-program pass voltage is lower than the program pass voltage.
